(19)

Europäisches
Patentamt
European
Patent Office
Office européen
des brevets

(11) **EP 1 236 436 B1**

(12) **EUROPEAN PATENT SPECIFICATION**

(45) Date of publication and mention
of the grant of the patent:
**07.04.2010 Bulletin 2010/14**

(51) Int Cl.:
***G01R 33/561*** (2006.01)

(21) Application number: **00980007.9**

(86) International application number:
**PCT/JP2000/008701**

(22) Date of filing: **08.12.2000**

(87) International publication number:
**WO 2001/041639 (14.06.2001 Gazette 2001/24)**

(54) **MAGNETIC RESONANCE IMAGING METHOD AND APPARATUS**

MAGNETRESONANZVERFAHREN UND -GERÄT

PROCEDE ET DISPOSITIF D'IMAGERIE PAR RESONANCE MAGNETIQUE

(84) Designated Contracting States:
**DE FR GB IT NL**

(30) Priority: **08.12.1999 JP 34932399**

(43) Date of publication of application:
**04.09.2002 Bulletin 2002/36**

(73) Proprietor: **HITACHI MEDICAL CORPORATION**
**Tokyo 101-0047 (JP)**

(72) Inventors:
- **TAKAHASHI, Tetsuhiko**
  **Souka-shi, Saitama 340-0011 (JP)**
- **TAKIZAWA, Masahiro**
  **Kashiwa-shi,**
  **Chiba 277-0803 (JP)**

(74) Representative: **Strehl Schübel-Hopf & Partner**
**Maximilianstrasse 54**
**80538 München (DE)**

(56) References cited:
**WO-A1-98/21600      JP-A- 4 005 951**
**JP-A- 4 075 637      JP-A- 7 031 606**
**JP-B1- 2 952 228**

- **JAKOB P M ET AL: "AUTO-SMASH: A SELF-CALIBRATING TECHNIQUE FOR SMASH IMAGING" MAGNETIC RESONANCE MATERIALS IN PHYSICS, BIOLOGY AND MEDICINE, CHAPMAN AND HALL, LONDON, GB, vol. 7, no. 1, November 1998 (1998-11), pages 42-54, XP001012838 ISSN: 1352-8661**

**Description**

FIELD OF THE INVENTION

The present invention relates to a nuclear magnetic resonance imaging (MRI) method and apparatus for measuring nuclear magnetic resonance (hereinafter this is referred to as "NMR") signal continuously from hydrogen or phosphorus in an object to be examined, and imaging density distribution and relaxation time distribution or the like of nuclear in the object.

BACKGROUND OF THE ART

As a receiving coil to detect NMR signal generated from the object in MRI apparatus, high sensitivity coil called "multiple RF coil" or "phased array coil" is used in recent years. (Japanese Patent laid open No. 2-500175 etc.). A multiple RF coil is a reception dedication coil composed of arraying plural number of small type RF co1l4 having relatively high sensitivity. It is made to obtain receiving signal of wide field of view with high sensitivity, and various types of it are proposed corresponding to static magnetic field type or detecting part. In addition, signal received with each unit coil of this multiple RF coil is composed to be imaged.

On the other hand, a method to shorten imaging time by thinning out data of the direction of phase encode direction and using multiple coil is proposed (for example, [4] Daniel K Sodickson, Warren J Manning "Simultaneous obtainment of spatial harmonics(SMASH): fast imaging with radio frequency coil arrays" Magnetic Resonance in Medicine 38,591-603, (1997), [5] J.Wang, A.Reykowski "A SMASH/SENSE related method using ratios of array coil profiles" ISMRM 99, etc.) This kind of technology is called space encode method or parallel MRI. An aliasing artifact in thinning phase encode data is removed using the spatial difference between each sensitivity distribution of multiple RF coil. For the removal of this aliasing artifact, highly accurate calculation using highly accurate sensitivity distribution of RF coil is necessary. This operation is performed in measurement space (k space) in the method described in the above literature [4]. And in the method described in the literature [5], it is performed in real space after Fourier transformation.

Generally, sensitivity distribution of RF coil can be calculated from each RF receiving signals. Concretely, the method that images the phantom having the uniform density previously and regards spatial shading of image as sensitivity distribution of RF coil, and the method that calculates it by making low frequency filter work on image measured separately to the object, are known.

However, these traditional methods mentioned above involve the following problem. That is, the process of calculating sensitivity distribution of said RF coil is performed before imaging. Then, for example in imaging the part of the object like abdomen, which changes its shape temporally in accordance with breathing, shape of the object examined can be different between at the time of sensitivity distribution calculated and at the time of imaging performed. Also, spatial arrangement of RF coil fitted to the object can be changed in accordance with the above change. In addition, in case of imaging the patient in surgical operation, position of RF coil can be changed along with time.

And also, in case it is demanded to display these images in real time, traditional method using sensitivity data of the coils obtained previously can lead to an error and then the quality of imaged can be deteriorated.

Furthermore, measuring sensitivity distribution of RF coil prior to imaging extends total imaging time, and so it holds a problem of deteriorating the effect of short-time imaging which is the characteristic of this technology.

The present invention is done for the purpose of solving the above-mentioned problems.

Jakob et al describe a self-calibrating technique for SMASH imaging in MAGMA 7: pages 42-54, 1998. The present independent claims have been cast in the two-part form in view of this document.

JP-07-031 606 discloses a conventional method for correcting the brightness of an image based on the sensitivity distribution of a single surface coil calculated from the low spatial frequency component of the image.

DISCLOSURE OF THE INVENTION

To solve the above-mentioned problems, from the first viewpoint, magnetic resonance imaging method and apparatus of the present invention as defined in the claims is provided.

According to the present invention, because sensitivity distribution of small type RF coil is calculated from data obtained in measurement for imaging, there is no difference in time between sensitivity distribution data and measured data. Then even in MRI measurement in which condition changes from time to time, it is easy to maintain stability. And even in measurement that demands real-time measurement, error is not invited and an image quality, is not deteriorated.

And according to an embodiment of the present invention; as filtering is performed so as to connect the data of low region to zero smoothly in calculating sensitivity distribution using data of low region in k space, sensitivity distribution with no influence of aliasing artifact can be calculated.

Also, as sensitivity distribution of RF coil is measured prior to imaging using measured data for imaging, without measuring sensitivity distribution of RF coil, total imaging time do not have to be extended and effect of imaging in short time does not be damaged.

According to the present invention, in the embodiment of measuring the image continuously, collection of measured data and image reconstruction following it are performed continuously, and control to display plural number of image that last in terms of time is performed, and image reconstruction means uses sensitivity distribution calculated from one measured data for reconstructing plural number of images. Thus in dynamic imaging in parallel MRI, time for image reconstruction can be shortened and then real-time measurement can be improved.

BRIEF DESCRIPTION OF THE DRAWINGS

Fig.1 is a block diagram of MRI apparatus applied to the present invention,
Fig.2 is a block diagram showing the main part of MRI device shown in Fig.1,
Fig.3 is a diagram showing one embodiment of pulse sequence applied to MRI apparatus of the present invention,
Fig.4 is a diagram showing one example of k space data array of measured data based on sequence in Fig.3,
Fig.5 is a schematic block diagram showing one embodiment of procession of signal procession part in MRI apparatus of the present invention,
Fig.6 is a view describing sensitivity distribution calculation of the present invention,
Fig.7 is a view describing sensitivity distribution calculation of the present invention,
Fig.8 is a view describing one embodiment of signal composition of the present invention,
Fig.9 is a view describing another embodiment of signal composition of the present invention,
Fig. 10 is a view showing one embodiment of continuous imaging due to MRI apparatus of the present invention,
Fig.11 is a view showing another embodiment of pulse sequence adopted to MRI apparatus of the present invention,
Fig.12 is a view showing another example of k space data array of measured data of the present invention,
Fig.13 is a view describing another embodiment of sensitivity distribution calculation of the present invention

BEST MODE FOR CARRYING OUT OF THE INVENTION

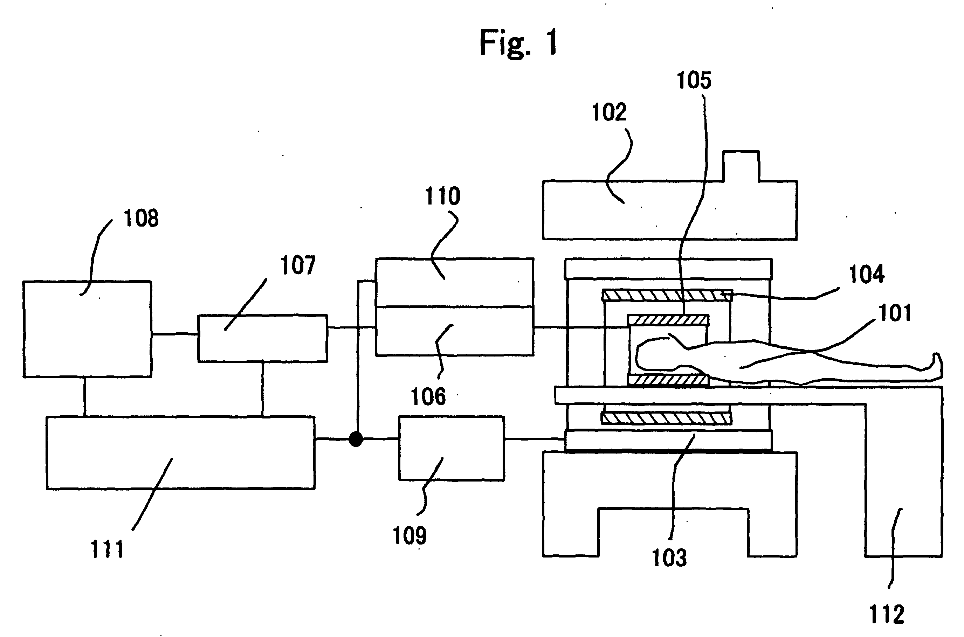

Hereinafter, the embodiment of the present invention will be described referring to the figures. Fig. 1 is a view showing the composition of typical MRI apparatus applied to the present invention. This MRI apparatus comprises magnet 102 for generating static magnetic field around the object to be examined 101, gradient magnetic field coil 103 for generating gradient magnetic field to said space, RF coil for signal transmitting 104 for generating high frequency magnetic field to this region, RF coil for signal receiving 105 for detecting NMR signal generated from the object to be examined 101, and the bed 112 on which the object to be examined 101 lies.

Gradient magnetic field coil 103 is composed of one pair of coil generating gradient magnetic field to three directions X, Y, Z, being perpendicular to each other, and each gradient magnetic field coil generates gradient magnetic field in accordance with the signal output from gradient magnetic field power supply 109. By changing the applying method of gradient magnetic field arbitrary slice of the object 101 can be selected, and position information can be given in MR signal. Gradient magnetic field applying position information to MR signal is called phase encode gradient magnetic field, or readout gradient magnetic field, by which measuring space (k space) where measured data is disposed is provided.

RF coil 104 generates high frequency magnetic field in accordance with signal of RF signal transmitting part 110. Frequency of this high frequency magnetic field is tuned with resonant frequency of nuclear spin that is an imaging target. An imaging target of ordinary MRI is proton, which is the main constituent material of the object. The signal received by RF coil 105 is detected in signal detection part 106, and is processed in signal processing part 107, and also converted to image signal with calculation.

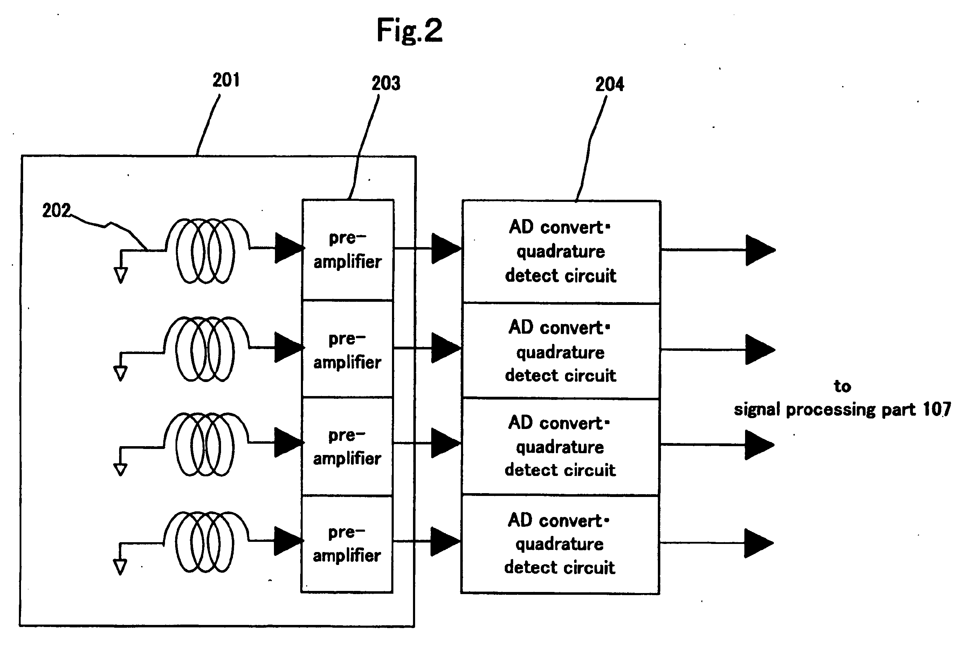

RF coil 104 is a multiple coil 201 arranged with plural number of small type RF coil 202 (in the figure of the example, four coils are arranged) as shown in Fig.2. As for each small type RF coil 202, for example, rectangular surface coil of 15 cm in one side disposed adjacently can be used, and those adjacent rectangular coils are disposed to overlap one part in phase encode direction of measurement. They have detecting sensitivity regions divided each other.

Each small type RF coil 202 is connected respectively to preamplifier 203, and output from each coil is amplified respectively in preamplifier 203. Each preamplifier 203 is respectively connected in parallel to AD convert quadrature detect circuit 204, and they compose signal detecting part 106. Signal detected in AD convert · quadrature detect circuit 204 is transferred to signal processing part 107 to perform Fourier transformation, filtering, composition calculation or the like for each coil. Those MRI apparatus having signal detecting part of plural number of system connected to multiple coil and each RF coil for composing it may be called parallel MRI system. Process performed at signal processing part 107 is previously programmed to build in to controlling part or memory device, which are described later.

In Fig.1, gradient magnetic field power supply 109, RF transmitting part 110, signal detecting part 106 are controlled with their movement by controlling part 111, in accordance with time chart generally called pulse sequence. In MRI apparatus of the present invention, controlling part 111 controls application step of phase encode in one part of region ofk space to be rough.

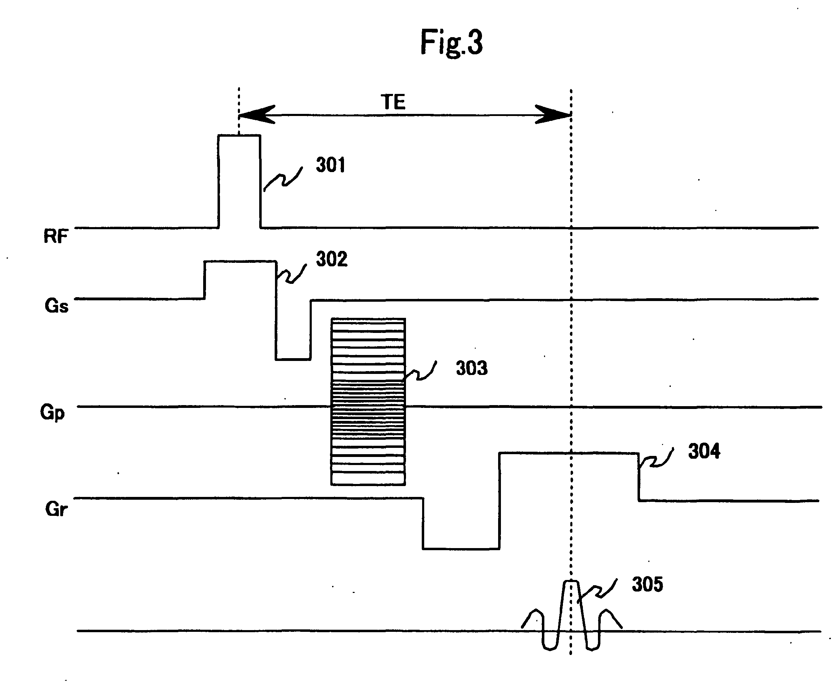

Next, imaging method using MRI apparatus of the above-mentioned composition will be described referring to Fig.3 - Fig.9.

FIG.3 is a view showing one example of pulse sequence adopted for continuous imaging. This pulse sequence is a gradient echo (GrE) method. After applying RF pulse 301 together with slice encode gradient magnetic field pulse 302 and generating transverse magnetization by exciting nuclear spin in specified region of the object to be examined, phase encode gradient magnetic field pulse 303 is applied, and then readout gradient magnetic field pulse 304 is applied and echo signal 305 is measured. TE (echo time), which is the time by the point echo signal reaches its peak value between applying RF pulse and after measuring of echo signal 305, is a parameter to define contrast of image and is set in advance considering organization or the like of the target.

By repeating these sequence plural number of times with changing application amount of phase encode gradient magnetic field (this is the integrated value of gradient magnetic field intensity and application time), obtained data is disposed to k space.

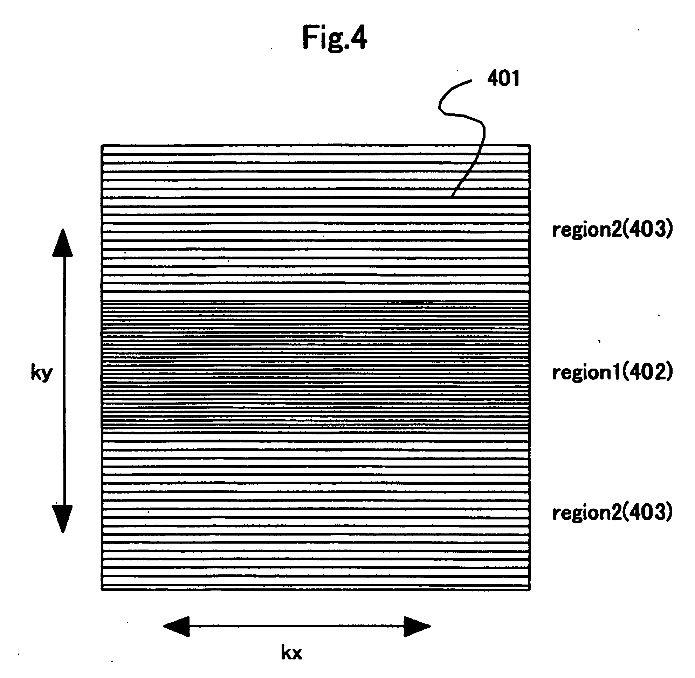

Fig. 4 is a view showing k space data arrangement (k trajectory) of measured data that is measured with repetition of said sequence, and with signal obtained by performing one pulse sequence one line of k space in transverse direction (kx direction) is filled up. And also, value of ky in k space is defined with application amount of phase encode gradient magnetic field given to measured NMR signal. In usual GrE sequence, step of phase encode amount has equal interval at each measurement. But in the sequence of this embodiment, phase encode step in region 1 (402) differs from that in region 2 (403) on k space. For example, in region 1(402) occupying low region (low spatial frequency region) part in phase encode direction, signal is obtained thickly in phase encode (ky) direction. On the other hand, in region 2 (402) occupying high region (high spatial frequency region) part, signal is obtained roughly in phase encode direction. For example, in the data region where 10 % up and down from the center of k space (20% of center part in all), phase encode amount is increased one step at a time. But when it exceeds more than 10% each up and down, phase encode amount is increased two or four step at a time. As a result, the whole imaging time can be shortened because the number of executing pulse sequence is reduced for thinned number.

The ratio in the whole k space occupied by region 1 (402) (about 20% in the embodiment of the present invention) can be set appropriately by considering both coil sensitivity and shortening of measuring time. When coil sensitivity is sharp, it is preferable to increase the ratio. On the other hand, it is preferable to reduce the ratio from the viewpoint of shortening measuring time. Data arrangement to k space is typically 256 x256 matrix in the direction of kx and ky. In region 1 (402), data is collected in this density. In region 2 (403), data is sampled two to four times roughly of said typical data arrangement in the direction of phase encode. This means that data measurement is performed in region 1 (402) with matrix by which field of view (FOV) can be displayed in 256 pixel in phase encode direction, and measurement is performed in region 2 to make FOV 1/2 to 1/4.

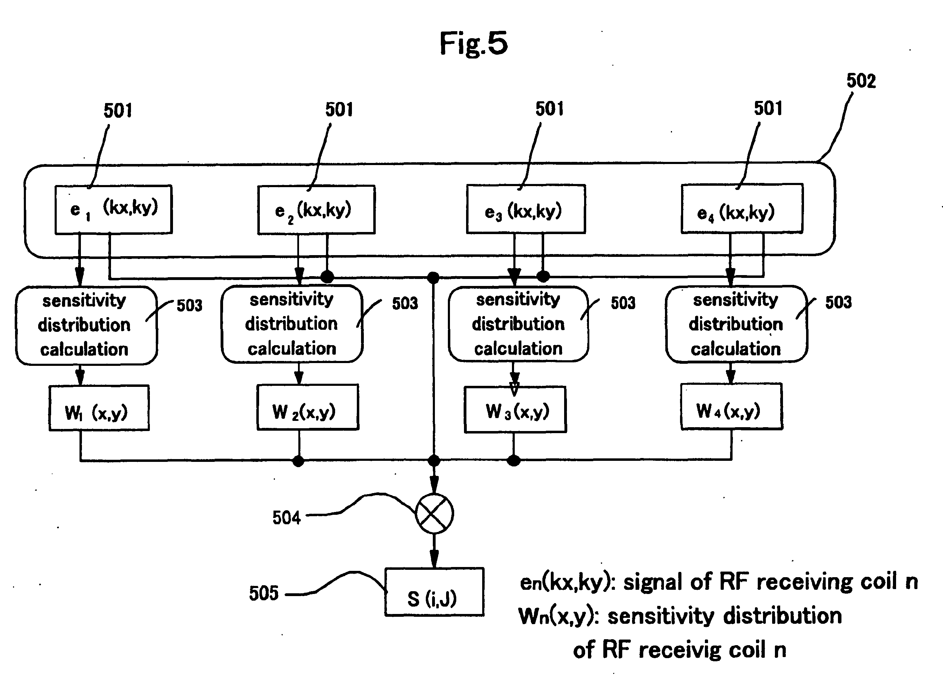

The measured data is transferred to signal processing part 107 per receiving coil, and measured data per receiving coil is taken in different k space. Then, as shown in Fig. 5, sensitivity distribution of each receiving coil is calculated with data of each receiving coil(503), and composing process of image is performed with sensitivity distribution of those each receiving coil and signal from each receiving coil (504). That is, by using signal $e_n$ (kx, ky) from each coil, sensitivity distribution image $W_n$ (x, y) of each coil is calculated (Here, n given to en and $W_n$ means coil number. In this embodiment n is 1,2,3 or 4. And also, (kx,ky) shows coordinates of k space and (x, y) shows position of real space). By using sensitivity distribution image and signal, the entire image S(x, y) 505 is composed. These sensitivity distribution calculation 503 and composing process 504 will be described in more detail.

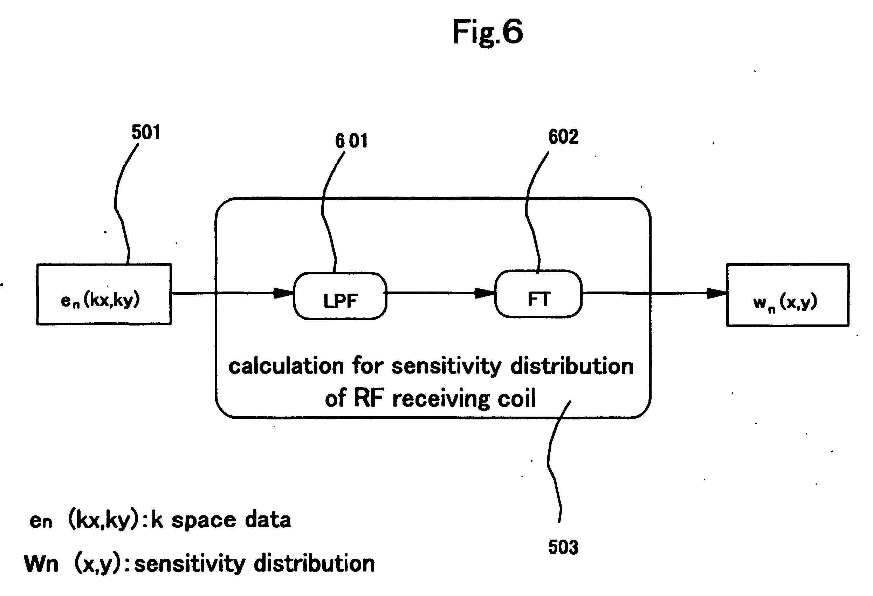

FIG.6 is a view showing procedure to calculate sensitivity distribution of RF coil from signal $e_n$(kz,ky) 501 of each receiving coil. At first, low pass filter (LPF) 601 is made to act so as to remain only data of region 1 to signal $e_n$(kx, ky) in phase encode direction. This filtering process is performed as a pre-processing to remove the aliasing artifact that is generated in phase encode direction by difference of FOV in measuring region1 (402) and region2 (402), when Fourier transformation is performed to the whole k space(401) with region 1 (402) and region 2 (403). To remove aliasing artifact, one-dimensional filter can be used, but two-dimensional filter is preferable to one dimension for removing minute structure of a living body. For example, gaussian type, humming type, hanning type are suitable for 2 dimensional filters. As a more highly precise filtering method, it is possible to use the method using flying window in image space.

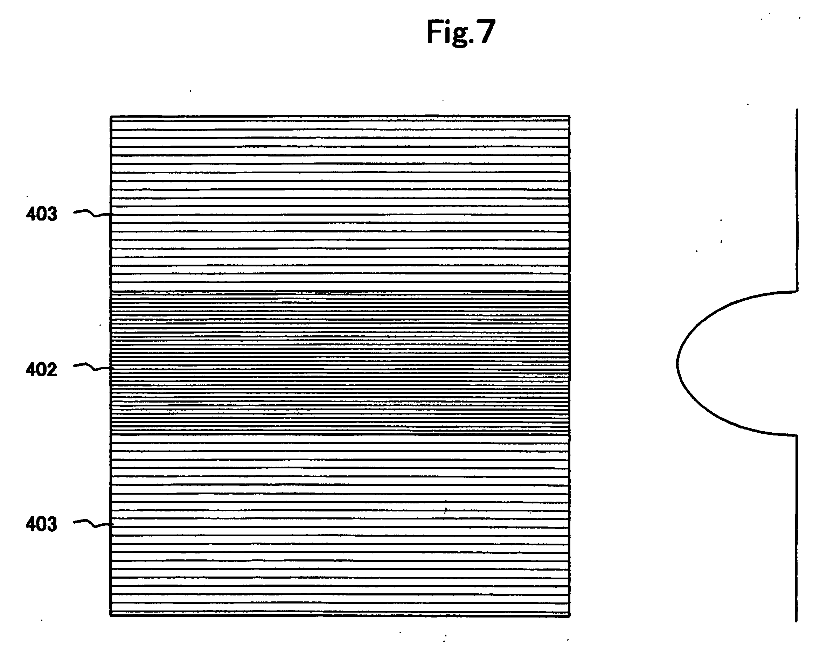

Fig. 7 shows correspondence between k space and filter profile of filter in said filtering process. When filtering is performed to k space with the filter having these filter profile, all of the data of region 2(403) shown in Fig. 7 are zero, and the boundary part between region 1 (402) and region 2 (403) can be connected smoothly. It is effective to connect smoothly the boundary part between these region 1 (402) and region 2 (403) rather than to change it sharply for preventing generation of aliasing artifact

Next, measured data arranged in region 1 in k space corresponding to each coil is performed two-dimensional Fourier transformation (FT) 602. But before that, matrix of each k space served for two-dimensional Fourier transformation is made to be the density for measurement of region 1, and region 2 in each k space is filled with zero. And being performed two-dimensional Fourier transformation is performed at each k space, image composed only of low frequency component in signal measured at each coil can be taken out respectively. It is known that these low frequency images are regarded as sensitivity distribution of each RF coil. In this embodiment, this is defined to be sensitivity distribution Wn(x,y) in the embodiment.

Incidentally, in multislice imaging, sensitivity distribution of coils need to be calculated at each slice of each coil. And, because the signal obtained at each coil becomes the function of three-dimensional measuring space (kg,ky, kz) in case of three dimensional imaging, it is possible to calculate three-dimensional sensitivity distribution Wn(x, y, z) of the coil by expanding Fourier transformation to three dimension by using three-dimensional filter to the low pass filter. Next, operation 504 for obtaining composed image by using this sensitivity distribution Wn(x,y) will be described. This composing calculation involves method for performing in imaging space (real space) and method for performing in measuring space. Both of them can be adopted.

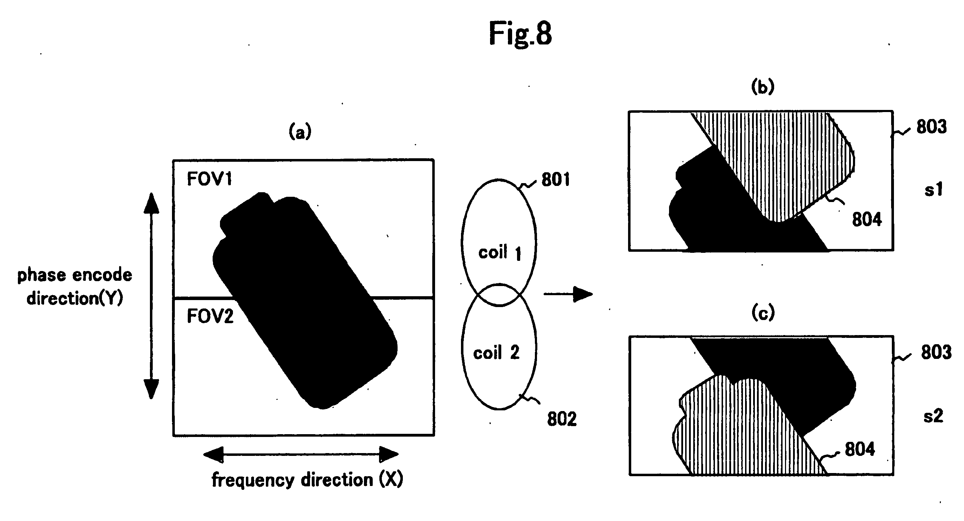

View for explaining conceptionally the method for performing composition of image in imaging space is shown in Fig. 8. To simplify the explanation, it will be explained in case of imaging the object by using multiple coil composed of two small type coil 801, 802.

In this case, coil 801 has FOV1, and coil 802 has FOV2. Sensitivity distribution of each coil overlaps each other at least one part. Measurement of NMR signal is, for example, performed with GrE sequence shown in Fig.3, and echo signals measured at coil 801 or coil 802 are arranged respectively to k space as shown in Fig.4. As explained above, performing two-dimensional Fourier transformation to two k spaces that take in signal separately from two coils, at the data is collected roughly (by thinning out) in phase encode direction in region 2 of k space, as shown in Fig.4, then, image coming from coil 1 (801) is reconstructed as shown in Fig. 8(b), and image coming from coil 2 (802) is reconstructed as shown in Fig. 8(c). And at each image, aliasing artifact 804 is generated in phase encode direction on image 803. These artifacts become low brightness because they are signal from low sensitivity region at each coil.

The aliasing artifact 804 can be removed by multiplying artifact sensitivity distribution of each small type coil, and obtain the image having no overlapping on images due to aliasing artifact as shown in Fig. 8(a). This method can be referred to in the section "SENSE" of said documents disclosed by said J. Wang et al., therefore the detailed explanation will be omitted.

In the method of composing signal in measuring space, the composed sensitivity distribution obtained by composed sensitivity distribution of each small type RF coil with appropriate weights is defined so as to have desired spatial frequency in accordance with the number of small type RF coil composing multiple coil. Then the data lacking in imaging space is made up.

For example, it assumes that composed sensitivity distribution Wcomp(x,y) of the form exp(i · m∆ ky · y) [here m is the integer] can be obtained by composed sensitivity distribution Wn(x,y) of small type RF coil with appropriate weight Cn.

$$\mathbf{Wcomp(x,y)} = \Sigma\, \mathbf{CjWj(x,y)} = \mathbf{exp(im\, \Delta\, kyy)}$$

Signal S(kx,ky) composed at this point is shown in the next equation.

$$\mathbf{S(kx,ky)} = \iint \mathbf{dxdy\, Wcomp(x,y)}\, \rho\, \mathbf{(x,y)exp\{-ikxx-ikyy\}}$$

$$= \iint \mathbf{dxdy}\, \rho\, \mathbf{(x,y)exp\{-ikxx-i(ky-m\, \Delta\, ky)y\}}$$

$$= \rho\, \mathbf{\hat{}\,(kx,\ ky-m\, \Delta\, ky)}$$

In the equation (2), ρ shows magnetization density, and ^ shows two-dimensional Fourier transformation. As is understood from the equation (2), ρ ^(kx,ky-m ∆ ky) can be calculated from p ^(kx,ky) by using composed sensitivity distribution Wcomp(x,y). This means that data in the interval between data roughly arranged in the phase encode direction of k space can be filled.

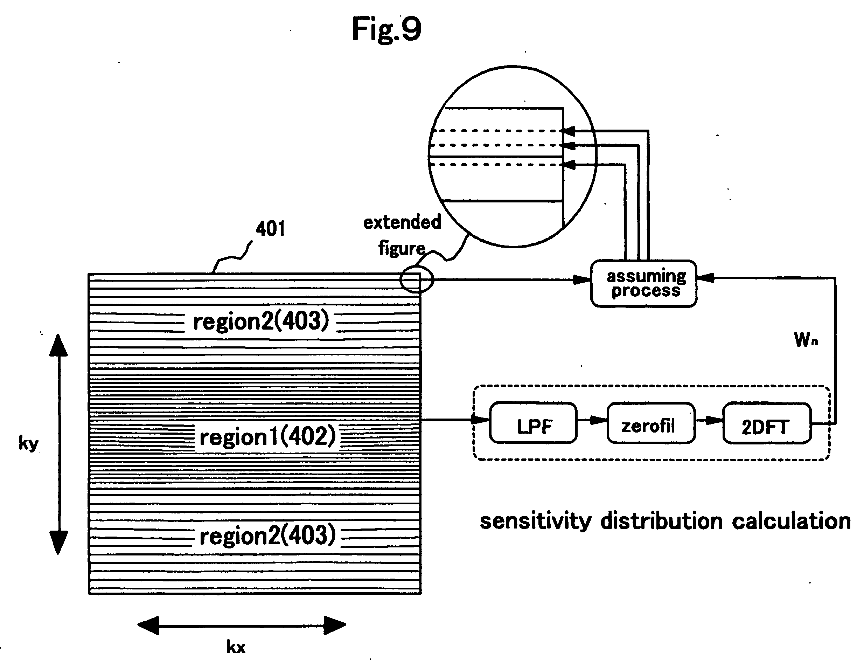

Fig. 9 is the view showing this method conceptionally. As shown in the figure, at first, sensitivity distribution can be calculated with zero filling (making data to be zero in the region 2 of k space except region 1 with the density of region 1) and two-dimensional Fourier transformation procession (2DFT) to measured data in region 1 (402) extracted with LPF procession. Next, for region 2 (403) where measured data is arranged roughly by thinning out, lacking data (corresponding to the dotted line in the enlarged figure) is formed from measured data (corresponding to solid line in enlarging figure) from said calculation. The number of new data (number of dotted line) formed by said process depends on the number of small type RF coil. When number of small type RF coil is four, four arrangement of new data can be formed. In the example shown in the figure, the case of thinning-out rate being four and number of forming data being three is shown.

Thus, the data after being supplemented the obtained new data is the same as the data measured without thinning out the entire region of k space, and image without aliasing artifact can be obtained by performing two-dimensional Fourier transformation to these data. Incidentally, as this method can be referred to in said document "SMASH" written by Daniel K Sodickson et al, the detailed explanation will be omitted.

According to the embodiment of the present invention, imaging is performed with shortening the time by thinning out a part of phase encode, and RF coil sensitivity distribution is obtained with no influence of aliasing using data in precise part of measured data obtained for the imaging. Then, time difference between the measurement for calculating sensitivity distribution and the measurement for imaging can be eliminated, and operation error following the time difference can be eliminated.

In addition, according to the embodiment of the present invention, by obtained especially thick data of low phase encode component including main image information in measured data, S/N of the images are hard to be deteriorated and the extremely effective images can be offered in an diagnosis of clinical application. Moreover, by adding the process of performing Fourier transformation thickly to the two-dimensional image(256 × 256 pixels) without aliasing artifact obtained by said method again in the phase encode direction, and replacing the data estimated in the low region of phase encode direction from the data obtained (appearing alternately on phase encode) with measured data already obtained thickly (Fourier transformed already in readout direction), or adding and averaging the estimated data and actual measured data on hybrid space, obtained data in region 1 can be utilized not only for removing aliasing artifact but also 100% as a data element for imaging reconstruction. Therefore, final image with high S/N can be obtained.

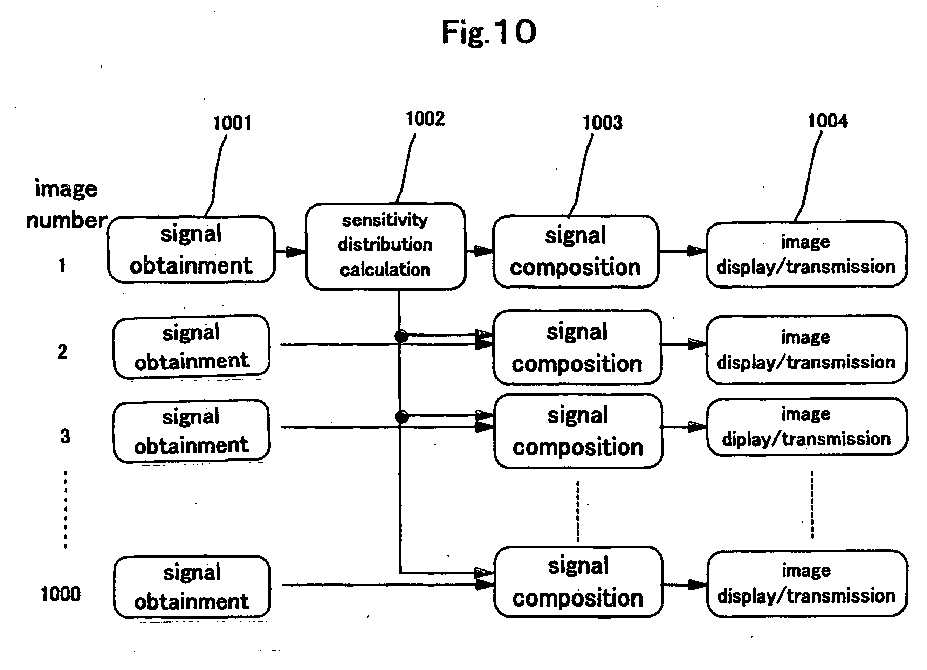

Furthermore, according to the embodiment of the present invention, it is not needed to perform previously measurement for calculating sensitivity distribution of coil. Then, not only time-shortening effect in measurement for imaging but also shortening of measuring time as a whole can be achieved. In case of continuous imaging, it is preferable to have both the effect of said high S/N and the time-shortening effect of imaging. Fig. 10 shows the embodiment that the present invention is applied to a dynamic imaging for obtaining continuous image in real time by repeating imaging in time series. In a dynamic imaging of this embodiment, signal obtained respectively at each small type RF coil of multiple coil is composed, and image display/transfer is repeated continuously, and continuous image (image number1,2,3 · · · 1000) is obtained in time series. In the first image obtainment, each step of signal obtainment 1001, sensitivity distribution calculation 1002, signal composing 1003 are performed similarly to the steps 502, 503, 504 which are shown in Fig. 5, and image of which the aliasing artifact is removed is reconstructed by using sensitivity distribution calculated in sensitivity distribution calculation 1002. This image is displayed on the display of MRI apparatus, or transferred to external display device or memory device (1004). Calculation result of sensitivity distribution calculated at the first image obtainment is memorized in the specified address of memory in signal processing part.

Next, the second image is obtained. When the second image is obtained, composing procession 1003 to remove aliasing artifact is performed by using sensitivity distribution data calculated in the first image obtainment memorized in memory after the signal obtainment. After that, as long as the disposition of signal receiving coil does not change, calculation of sensitivity distribution is not performed and composing process is performed using sensitivity distribution data in memory. As sensitivity distribution does not change when the disposition of receiving coil does not change, calculation result of sensitivity distribution calculated first as described above can be used. Thus even when the imaging interval (interval between an image obtainment and the next) is shortened in dynamic imaging, operation for imaging can be performed quickly, and the ability to display in real time (time resolution) can be improved.

For example, when fast sequence such as EPI is adopted as imaging sequence, it is important to make operation fast for performing effective continuous fast imaging, and the condition of the object can be monitored in real time by applying the embodiment shown in Fig. 10.

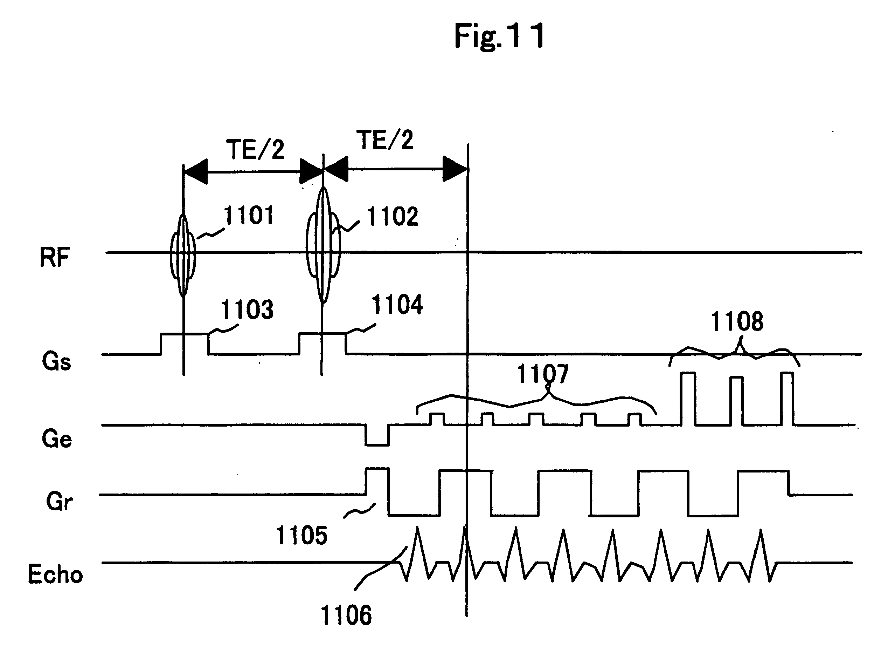

Next, MRI apparatus that installs the EPI sequence suitable for MRI apparatus described above will be explained. In this embodiment, the composition of the apparatus is the same as one shown in Fig. 1. The MRI apparatus in this embodiment installs EPI sequence for controlling collection of measured data as a control sequence in control part 111 so as to have different density at each region of measuring space (k space). Fig. 11 is the view showing one embodiment of such EPI sequence, and EPI sequence of the spin echo type is shown there. That is, RF pulse 1101 for exciting nuclear spin of organization of the object and slice selective gradient magnetic field pulse Gs 1103 are applied, and after TE/2 time RF pulse 1102 for inverting transverse magnetization generated from the first RF pulse 101 is applied, together with slice selective gradient magnetic field pulse Gs 1104, and after that, echo signal 1106 is measured with applying continuously readout gradient magnetic field 1105 that alternates its polarity. In this procedure, phase encode gradient magnetic field Ge 1107 and 1108 for phase encoding echo signal are applied.

In the ordinary EPI sequence, for example, if matrix size of k space is 128 × 128, readout gradient magnetic field is inverted 128 times, and 128 echo signals are measured. Phase encode gradient magnetic field pulse is applied with 128 pulse with the same size of it other than the first offset pulse. But in EPI sequence of the present embodiment, for example, echo signal of from phase encode 0 that of to predetermined phase encode is applied with phase encode gradient magnetic field pulse 1107 of such size that the number of phase encode increments one by one. Echo signal measured after that is applied with phase encode gradient magnetic field pulse 1108 of such size that it increments 4 at each step.

In the example shown in the figure, the case of measuring 8 echo signals is shown for simple explanation. Until the fifth signal measurement, phase encode gradient magnetic field pulse 1107 of ordinary size is applied. From sixth to eighth signal measurement, phase encode gradient magnetic field pulse 1108 of the size 4 times as large as ordinary size is applied. Signals from the first to the fifth measurement shown in Fig. 4 correspond to region 1 (402) in k space, and signals from the sixth to the eighth measurement correspond to region 2(403). Then, whereas signals from the sixth to the eighth measurement have hitherto needed time for measuring 12(=3 × 4) signals, measuring time for nine (=12-3) signals can be shortened in this sequence. If it is described regarding k trajectory, measurement can be performed thickly in region 1 and can be performed roughly in region 2 with performing said sequence. In executing EPI sequence shown in Fig. 11, only the top or bottom part of region 2 shown in Fig. 4 is measured. In this case, the part that is not measured in region 2 is estimated by jointly using measured data, known half Fourier method and signal estimating procession method utilizing complex conjugation.

The present invention can be applied to not only spin echo type EPI described above but also gradient echo type EPI, and one shot type EPI collecting necessary measured data with one excitation or multishot type (division type) EPI.

The MRI apparatus based on the second embodiment of the present invention is suitable for use as a sequence of parallel MRI using said multiple coil. Also in the case of applying said EPI sequence to parallel MRI, process performed in signal processing part is the same as in the case of GrE sequence. In other words, as shown in Fig. 5, by performing sensitivity distribution calculation 503 at each small type RF coil composing multiple coil using data measured by said EPI sequence together with performing composing process 504 using the calculated sensitivity distribution, image of which aliasing artifact is removed can be obtained.

And in case of dynamic imaging, sensitivity distribution calculation is performed only in reconstruction of the first image as shown in fig. 10, and as for image after that process from signal obtainment to image display and transfer is performed continuously using the sensitivity distribution. In this case, as described above, signal obtaining time of EPI sequence of the present invention is shortened compared with ordinary EPI sequence. Besides, sensitivity distribution calculation of each signal obtainment does not need to be performed apart from measurement for imaging, or sensitivity distribution calculation. And so, extremely fast continuous imaging can be performed.

The above is the explanation for each embodiment of MRI apparatus of the present invention. However, it is possible to modify the present invention in various points, not limited by these embodiments. For example, though GrE sequence and EPI sequence is illustrated as a pulse sequence for using parallel MRI in the explanation above, the present invention can be also applied to the known sequence such as FSE (fast spin echo sequence), SE (spin echo sequence), Burst sequence, and spiral sequence. In addition, it can be also expanded to 3 dimensional imaging.

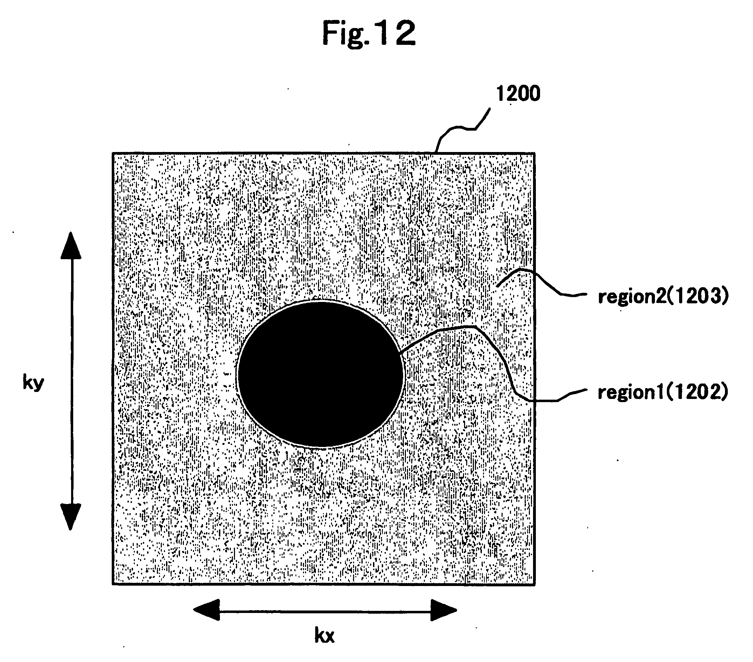

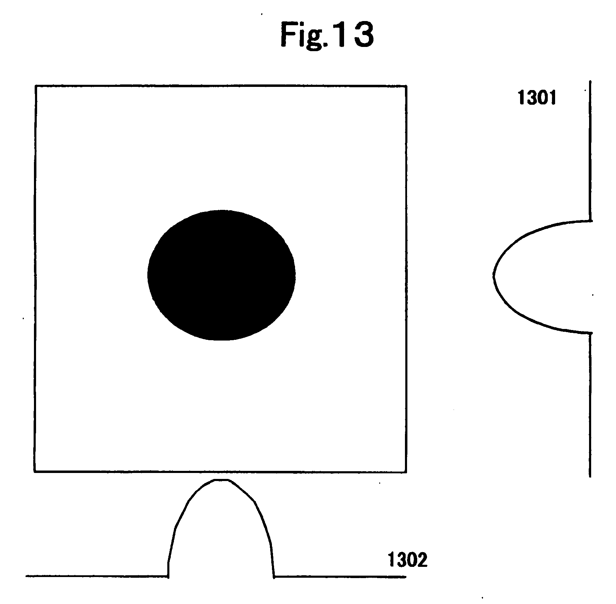

FIG. 12 is a view showing k trajectory 1200 in case of spiral sequence. In this case, circular region 1 of the center of k space (1202) is the region where signals are arranged thickly, and in region 2 surrounding it, signals are arranged roughly. To calculate sensitivity distribution from measured data of the spiral sequence, two-dimensional filter having filter profile 1301, 1302 shown in Fig. 13 is used. As this two-dimensional filter, said two-dimensional gaussian filter, two-dimensional hanning filter, two-dimensional hamming filter or the like are used. By using sensitivity distribution at each small type coil calculated from measured data of region 1 (1202), image of which aliasing artifact is removed is composed. This is the same as the case in another sequence.

According to the MRI apparatus of the present invention, in performing parallel MRI using multiple coil, imaging is performed shortening measuring time by thinning out one part of region in k space, and sensitivity distribution is calculated using data of region where measured data is thick to compose signals. Therefore, image quality is not deteriorated in imaging of which real-time nature is demanded. Especially, by obtaining data thickly of the low frequency component in k space, image having high S/N and high diagnosis value can be obtained.

Also, as there is no need to measure sensitivity distribution of RF coil before imaging, total measuring time is not extended. Therefore, the effect of imaging in short time, which is the characteristic of parallel MRI techniques, can be caused.

**Claims**

1.  A magnetic resonance parallel imaging method for imaging an object (101) to be examined at high speed by using the magnetic resonance phenomenon, comprising the steps of:

    (a) applying to the object (101), which is placed in a uniform static magnetic field, a predetermined pulse sequence (301-304) for NMR imaging, the pulse sequence including an RF pulse (301), a phase encode gradient magnetic field (303), and a read-out gradient magnetic field (304), and executing this pulse sequence repeatedly;
    (b) detecting an NMR signal (305) generated from the object (101) by executing step (a) at each one of a plurality of small type RF coils (202; 801, 802) forming a multiple coil arrangement (105; 201), and memorizing their NMR signals in a memory corresponding to a k space (401) separately for each RF coil;
    (c) calculating the sensitivity distribution of each coil (202; 801, 802);
    (d) performing an image composing process using the coil sensitivity distribution calculated in step (c) and measured data memorized in said memory,

    wherein the gradient steps of the phase encode gradient magnetic field (303) applied in measuring a low spatial frequency region (402) of said k space (401) are made smaller than those applied in measuring a high spatial frequency region (403), in the repeatedly executed pulse sequences (301...304),
    **characterized in that** said calculating step (c) provides the sensitivity distribution of each RF coil in image space by using data only of said low spatial frequency region (402) at each k space (401).

2.  The method of claim 1, wherein a low pass filter (601) is used for extracting the low spatial frequency region (402) alone of said k space (401) in calculating the sensitivity distribution at each RF coil (202; 801, 802), to make the data of the high spatial frequency region (403) zero and to form a smooth connection between the extracted region and the zero region.

3.  The method of claim 2, wherein
    the region of said k space (401), except the region where extracted data of the low spatial frequency region (402) alone is memorized, is filled with zeros with the same sampling density as the low spatial frequency region, and
    the k space (401) comprised of this low spatial frequency region (402) data and zero data of said other region is subjected to Fourier transformation to calculate the coil sensitivity distribution.

4.  The method of any preceding claim, further comprising the step of:

    executing a pulse sequence (301...304) for imaging a second image and composing said second image by applying said sensitivity distribution of said small type RF coils (202; 801, 802) to the obtained NMR signal.

5.  A magnetic resonance parallel imaging apparatus comprising:

    a magnet (102) arranged for generating a uniform static magnetic field within a space accommodating an object (101) to be examined;
    a multiple coil arrangement (105; 201) composed of a plurality of small type RF coils (202; 801, 802) for detecting an NMR signal (305) generated from said object (101);
    means (103...105) arranged for applying a predetermined pulse sequence (301-304) for NMR imaging, the pulse sequence including a high frequency magnetic field (301), a phase encode gradient magnetic field (303) and a read-out gradient magnetic field (304) to image said object (101);
    controlling means (111) arranged for controlling said magnetic field applying means (103...105);
    measured data memorizing means arranged for memorizing the NMR signal detected in said multiple coil arrangement (105; 201) corresponding to each small type RF coil (202; 801, 802);
    calculating means (503) arranged for calculating the sensitivity distribution of each small type RF coil (202; 801, 802); and
    image comprising means (504) arranged for composing an image from said sensitivity distribution and data memorized in said measured data memorizing means,

    wherein the controlling means includes means arranged for modifying the gradient steps of said phase encode gradient magnetic field (303) applied in measuring a low spatial frequency region (402) of a k space (401) to be smaller than those applied in measuring a high spatial frequency region (403),
    **characterized in that** said calculating means (503) is adapted to provide the sensitivity distribution of each RF coil in image space by using only data of said low spatial frequency region (402) in the k space (401) for each small coil (202; 801, 802).

6. The apparatus of claim 5, wherein said calculating means (503) includes
filter means (601) for extracting the data of the low spatial frequency region (402) from the data memorized in said measured data memorizing means, and
means (602) arranged for performing a two-dimensional Fourier transformation to composed data comprised of low spatial frequency region data extracted and zero data filed in the region outside the low spatial frequency region.

7. The apparatus of claim 6, wherein said filter means (601) has a filter profile for smoothing the connection of data between the low spatial frequency region extracted in the direction of phase encode and the high spatial frequency region filled with zero.

8. The apparatus of any of claims 5 to 7, wherein said small type RF coils (202; 801, 802) are arrayed to overlap adjacent coils in part.

9. The apparatus of any of claims 5 to 8, wherein
said controlling means is arranged for repeatedly executing a measurement for imaging a predetermined slice of an object (101) to be examined in an image unit,
said means for calculating the sensitivity distribution of each small type RF coil (202; 801, 802) of the multiple coil arrangement (105; 201) is adapted to use the measured data obtained for one of the repeatedly executed measurements,
said image composing means (504) is adapted to compose an image of all fields of view obtained from the individual coils in said multiple coil arrangement (105; 201) by using the sensitivity distribution calculated from said one of the repeatedly executed measurements, and to apply said sensitivity distribution without renewal to the image composition based on the measured data of the other repeatedly executed measurements after the calculation of the sensitivity distribution.

10. A magnetic resonance parallel imaging method for imaging an object (101) to be examined at high speed by using the magnetic resonance phenomenon, comprising the steps of:

(a) applying to the object (101), which is placed in a uniform static magnetic field a predetermined pulse sequence (301-304) for NMR imaging, the pulse sequence including an RF pulse (301) and a read-out gradient magnetic field (304) in accordance with a predetermined pulse sequence, and executing this pulse sequence repeatedly;
(b) detecting MR signals (305) generated from the object (101) by executing step (a) at each one of a plurality of small type RF coils (202; 801, 802) forming a multiple coil arrangement (105; 201), and memorizing their NMR signals in a memory corresponding to the k space (1200) separately for each RF coil;
(c) calculating the sensitivity distribution of each coil (202; 801, 802);
(d) performing an image composing process using the coil sensitivity distribution calculated in step (c) and measured data memorized in said memory,

wherein the NMR signals in a low spatial frequency region (1202) of said k space (1200) are measured more densely than in a high spatial frequency region (1203), in the repeatedly executed pulse sequences (301...304), **characterized in that** said detecting step (b) is made along a spiral trajectory through k space (1200) and **in that**
said calculating step (c) provides the sensitivity distribution of each RF coil in image space by using data only of said low spatial frequency region (1202) at each k space (1200).

11. A magnetic resonance parallel imaging apparatus comprising:

a magnet (102) arranged for generating a uniform static magnetic field within a space accommodating an object (101) to be examined;
a multiple coil arrangement (105; 201) composed of a plurality of small type RF oils (202; 801, 802) for detecting an NMR signal (305) generated from said object (101);
means (103...105) arranged for applying a predetermined pulse sequence (301-304) for NMR imaging, the pulse sequence including a high frequency magnetic field (301) and a read-out gradient magnetic field (304) to image said object (101);
measured data memorizing means arranged for memorizing the NMR signal detected in said multiple coil arrangement (105; 201) corresponding to each small type RF coil (202; 801, 802);

means (503) arranged for calculating the sensitivity distribution of each small type RF coil (202; 801, 802); and
means (504) arranged for composing an image from said sensitivity distribution and data memorized in said measured data memorizing means,

wherein the controlling means includes means arranged for measuring the NMR signals in a low spatial frequency region (1202) of said k space (1200) more densely than in a high spatial frequency region (1203), **characterized in that** the apparatus further comprises means (111) arranged for controlling said magnetic field applying means (103...105) to measure along a spiral trajectory through k space (1200); and **in that**
said calculating means (503) is adapted to provide the sensitivity distribution of each RF coil in image space by using only data of said low spatial frequency region (1202) in the k space (1200) for each small coil (202; 801, 802).

**12.** The method of any of claims 1 to 4, further comprising the step of:

obtaining a composed sensitivity distribution (Wcomp) which is a weighted sum of the sensitivity distributions (Wn) of each small type RF coil.

**13.** The method or apparatus of any preceding claim, used in an echo planar imaging (EPI) sequence.

**Patentansprüche**

**1.** Magnetresonanz-Parallelbildgebungsverfahren zum Abbilden eines mit Hochgeschwindigkeit zu untersuchenden Objekts (101) unter Verwendung des Magnetresonanz-Phänomens, wobei:

(a) eine vorbestimmte Pulssequenz (301-304) zur NMR-Bildgebung auf das Objekt (101) angewendet wird, das in einem gleichförmigen statischen Magnetfeld angeordnet ist, wobei die Pulssequenz einen HF-Puls (301), ein phasenkodiertes Gradientenmagnetfeld (303) und ein Auslese-Gradientenmagnetfeld (304) aufweist, und diese Pulssequenz wiederholt durchgeführt wird;
(b) ein von dem Objekt (101) erzeugtes NMR-Signal (305) erfasst wird, indem Schritt (a) an jeder von mehreren kleinen HF-Spulen (202; 801, 802) durchgeführt wird, die eine Mehrfachspulenanordnung (105; 201) bilden und deren NMR-Signale in einem Speicher entsprechend einem k-Raum (401) separat für jede HF-Spule gespeichert werden;
(c) die Empfindlichkeitsverteilung jeder Spule (202; 801, 802) berechnet wird;
(d) ein Bildzusammensetzungsprozess unter Verwendung der in Schritt (c) berechneten Spulenempfindlichkeitsverteilung und der in dem Speicher gespeicherten Messdaten durchgeführt wird,

wobei in den wiederholt ausgeführten Pulssequenzen (301 ... 304) die Gradientenschritte des phasenkodierten Gradientenmagnetfelds (303), das beim Messen einer Niedrigraumfrequenzregion (402) des k-Raums (401) angewendet wird, kleiner gemacht werden als diejenigen, die beim Messen einer Hochraumfrequenzregion (403) angewendet werden,
**dadurch gekennzeichnet, dass** der Berechnungsschritt (c) die Empfindlichkeitsverteilung jeder HF-Spule im Bildraum liefert, indem nur Daten der Niedrigraumfrequenzregion (402) jedes k-Raums (401) verwendet werden.

**2.** Verfahren nach Anspruch 1, wobei ein Tiefpassfilter (601) zum alleinigen Herauslösen der Niedrigraumfrequenzregion (402) des k-Raums (401) beim Berechnen der Empfindlichkeitsverteilung in jeder HF-Spule (202; 801, 802) verwendet wird, um die Daten der Hochraumfrequenzregion (403) zu Null zu machen und eine glatte Verbindung zwischen der herausgelösten Region und der Null-Region zu bilden.

**3.** Verfahren nach Anspruch 2, wobei
die Region des k-Raums (401) ausgenommen der Region, in der allein herausgelöste Daten der Niedrigraumfrequenzregion (402) gespeichert werden, mit Nullen mit der gleichen Probennahmedichte wie der Niedrigraumfrequenzregion gefüllt werden, und
der k-Raum (401) bestehend aus diesen Daten der Niedrigraumfrequenzregion (402) und Null-Daten der anderen Regionen einer Fourier-Transformation unterzogen wird, um die Spulendichteverteilung zu berechnen.

**4.** Verfahren nach einem der vorstehenden Ansprüche, wobei ferner:

eine Pulssequenz (301 ... 304) durchgeführt wird, um ein zweites Bild abzubilden, und das zweite Bild zusammengesetzt wird, indem die Dichteverteilung der kleinen HF-Spulen (202; 801, 802) auf das erhaltene NMR-Signal angewendet wird.

5. Magnetresonanz-Parallelbildgebungsgerät mit:

einem Magneten (102), der dazu ausgelegt ist, ein gleichförmiges statisches Magnetfeld innerhalb eines Raums zu erzeugen, der ein zu untersuchendes Objekt (101) aufweist;

einer aus mehreren kleinen HF-Spulen (202; 801, 802) zusammengesetzten Mehrfachspulenanordnung (105; 201) zum Erfassen eines NMR-Signals (305), das von dem Objekt (101) erzeugt wurde;

einer Einrichtung (103 ... 105) die dazu ausgelegt ist, eine vorbestimmte Pulssequenz (301-304) zur NMR-Bildgebung anzuwenden, wobei die Pulssequenz ein Hochfrequenz-Magnetfeld (301), ein phasenkodiertes Gradientenmagnetfeld (303) und ein Auslese-Gradientenmagnetfeld (304) aufweist, um das Objekt (101) abzubilden;

einer Steuereinrichtung (111), die dazu ausgelegt ist, die Magnetfeldanwendeeinrichtung (103 ... 105) zu steuern;

einer Messdatenspeichereinrichtung, die dazu ausgelegt ist, das in der Mehrfachspulenanordnung (105; 201) entsprechend jeder kleinen HF-Spule (202; 801, 802) erfasste NMR-Signal zu speichern;

einer Berechnungseinrichtung (503), die dazu ausgelegt ist, die Empfindlichkeitsverteilung jeder kleinen HF-Spule (202; 801, 802) zu berechnen; und

einer Bildzusammensetzungseinrichtung (504), die dazu ausgelegt ist, ein Bild aus der Empfindlichkeitsverteilung und den in der Messdatenspeichereinrichtung gespeicherten Daten zusammenzusetzen,

wobei die Steuereinrichtung eine Einrichtung aufweist, die dazu ausgelegt ist, die Gradientenschritte des beim Messen einer Niedrigraumfrequenzregion (402) eines k-Raums (401) angewendeten phasenkodierten Gradientenmagnetfelds (303) so zu modifizieren, dass sie kleiner sind als diejenigen, die beim Messen einer Hochraumfrequenzregion (403) angewendet werden,

**dadurch gekennzeichnet, dass** die Berechnungseinrichtung (503) dazu ausgelegt ist, die Empfindlichkeitsverteilung jeder HF-Spule im Bildraum zu liefern, indem nur Daten der Niedrigraumfrequenzregion (402) in dem k-Raum (401) für jede kleine Spule (202; 801, 802) verwendet werden.

6. Gerät nach Anspruch 5, wobei die Berechnungseinrichtung (503) aufweist:

eine Filtereinrichtung (601) zum Herauslösen der Daten der Niedrigraumfrequenzregion (402) aus den in der Messdatenspeichereinrichtung gespeicherten Daten, und

eine Einrichtung (602), die dazu ausgelegt ist, eine zweidimensionale Fourier-Transformation an zusammengesetzten Daten auszuführen, die aus den herausgelösten Niedrigraumfrequenzregion-Daten und Null-Daten zusammengesetzt sind, die in der Region außerhalb der Niedrigraumfrequenzregion aufgefüllt sind.

7. Gerät nach Anspruch 6, wobei die Filtereinrichtung (601) ein Filterprofil zum Glätten der Verbindung von Daten zwischen der Niedrigraumfrequenzregion, die in der Richtung der Phasenkodierung herausgelöst wurde, und der Hochraumfrequenzregion, die mit Nullen aufgefüllt ist, aufweist.

8. Gerät nach einem der Ansprüche 5 bis 7, wobei die kleinen HF-Spulen (202; 801, 802) so angeordnet sind, dass sie angrenzende Spulen teilweise überlappen.

9. Gerät nach einem der Ansprüche 5 bis 8, wobei
die Steuereinrichtung dazu ausgelegt ist, wiederholt eine Messung zur Bildgebung eines zu untersuchenden Objekts (101) in einer Abbildungseinheit auszuführen,
die Einrichtung zur Berechnung der Empfindlichkeitsverteilung jeder kleinen HF-Spule (202; 801, 802) der Mehrfachspulenanordnung (105; 201) dazu ausgelegt ist, die Messdaten zu verwenden, die für eine der wiederholt ausgeführten Messungen erhalten wurden,
die Bildzusammensetzungseinrichtung (504) dazu ausgelegt ist, ein Bild aller aus den einzelnen Spulen in der Mehrfachspulenanordnung (105; 201) erhaltenen Sichtfelder zusammenzusetzen, indem die aus der einen der wiederholt ausgeführten Messungen berechnete Empfindlichkeitsverteilung verwendet wird und die Empfindlichkeitsverteilung ohne Erneuerung auf die Bildzusammensetzung auf Grundlage der Messdaten der anderen wiederholt ausgeführten Messungen nach der Berechnung der Empfindlichkeitsverteilung anzuwenden.

10. Magnetresonanz-Parallelbildgebungsverfahren zum Abbilden eines bei hoher Geschwindigkeit zu untersuchenden Objekts (101), indem das Magnetresonanz-Phänomen verwendet wird, wobei:

(a) eine vorbestimmte Pulssequenz (301-304) zur NMR-Bildgebung auf das Objekt (101) angewendet wird, das in einem gleichförmigen statischen Magnetfeld angeordnet ist, wobei die Pulssequenz einen HF-Puls (301) und ein Auslese-Gradientmagnetfeld (304) gemäß einer vorbestimmten Pulssequenz aufweist, und diese Pulssequenz wiederholt ausgeführt wird;

(b) durch Ausführen von Schritt (a) an jeder von mehreren kleinen HF-Spulen (202; 801, 802), die eine Mehrfachspulenanordnung (105; 201) bilden, von dem Objekt (101) erzeugte NMR-Signale (305) erfasst werden, und deren NMR-Signale in einem Speicher entsprechend dem k-Raum (1200) separat für jede HF-Spule gespeichert werden;

(c) die Empfindlichkeitsverteilung jeder Spule (202; 801, 802) berechnet wird;

(d) ein Bildzusammensetzungsprozess unter Verwendung der in Schritt (c) berechneten Spulenempfindlichkeitsverteilung und in dem Speicher gespeicherter Messdaten durchgeführt wird,

wobei die NMR-Signale in den wiederholt ausgeführten Pulssequenzen (301 ... 304) in einer Niedrigraumfrequenzregion (1202) des k-Raums (1200) dichter gemessen werden als in einer Hochraumfrequenzregion (1203), **dadurch gekennzeichnet, dass** der Erfassungsschritt (b) längs einer spiralförmigen Trajektorie durch den k-Raum (1200) ausgeführt wird, und **dadurch**, dass der Berechnungsschritt (c) die Dichteverteilung jeder HF-Spule im Bildraum liefert, indem nur Daten der Niedrigraumfrequenzregion (1202) jedes k-Raums (1200) verwendet werden.

11. Magnetresonanz-Parallelbildgebungsgerät mit:

einem Magneten (102), der dazu ausgelegt ist, ein gleichförmiges statisches Magnetfeld innerhalb eines Raums zu erzeugen, der ein zu untersuchendes Objekt (101) aufnimmt;

einer aus mehreren kleinen HF-Spulen (202; 801, 802) zusammengesetzten Mehrfachspulenanordnung (105; 201) zum Erfassen eines von dem Objekt (101) erzeugten NMR-Signals (305);

einer Einrichtung (103 ... 105), die dazu ausgelegt ist, eine vorbestimmte Pulssequenz (301-304) zur NMR-Bildgebung anzuwenden, wobei die Pulssequenz ein Hochfrequenzmagnetfeld (301) und ein Auslese-Gradientenmagnetfeld (304) zum Abbilden des Objekts (101) aufweist;

einer Messdatenspeichereinrichtung, die dazu ausgelegt ist, die in der Mehrfachspulenanordnung (105; 201) entsprechend jeder kleinen HF-Spule (202; 801, 802) erfassten NMR-Signale zu speichern;

einer Einrichtung (503), die dazu ausgelegt ist, die Empfindlichkeitsverteilung jeder kleinen HF-Spule (202; 801, 802) zu berechnen; und

einer Einrichtung (504), die dazu ausgelegt ist, ein Bild aus der Empfindlichkeitsverteilung und in der Messdatenspeichereinrichtung gespeicherten Daten zusammenzusetzen,

wobei die Steuereinrichtung eine Einrichtung aufweist, die dazu ausgelegt ist, die NMR-Signale in einer Niedrigraumfrequenzregion (1202) des k-Raums (1200) dichter zu messen als in einer Hochraumfrequenzregion (1203), **dadurch gekennzeichnet, dass** das Gerät ferner eine Einrichtung (111) aufweist, die dazu ausgelegt ist, die Magnetfeldanwendeeinrichtung (103 ... 105) zu steuern, um längs einer spiralförmigen Trajektorie durch den k-Raum (1200) zu messen, und **dadurch**, dass die Berechnungseinrichtung (503) dazu ausgelegt ist, die Empfindlichkeitsverteilung jeder HF-Spule im Bildraum zu liefern, indem nur Daten der Niedrigraumfrequenzregion (1202) in dem k-Raum (1200) für jede kleine Spule (202; 801, 802) verwendet werden.

12. Verfahren nach einem der Ansprüche 1 bis 4, wobei ferner:

eine zusammengesetzte Empfindlichkeitsverteilung (Wcomp) verwendet wird, die eine gewichtete Summe der Empfindlichkeitsverteilungen (Wn) jeder kleinen HF-Spule ist.

13. Verfahren oder Gerät nach einem der vorstehenden Ansprüche, das in einer Echo-Planar-Imaging (EPI)-Sequenz verwendet wird.

**Revendications**

1. Procédé d'imagerie parallèle par résonance magnétique pour prendre des images d'un objet (101) à examiner à haute vitesse en utilisant le phénomène de résonance magnétique, comprenant les étapes consistant à :

(a) appliquer à l'objet (101), qui est placé dans un champ magnétique statique et uniforme, une séquence d'impulsions prédéterminée (301-304) pour de l'imagerie par RMN, la séquence d'impulsions comprenant une impulsion RF (301), un champ magnétique à gradient de codage de phase (303) et un champ magnétique à gradient de lecture (304), et exécuter cette séquence d'impulsions de manière répétée ;

(b) détecter un signal RMN (305) généré par l'objet (101) en exécutant l'étape (a) en chacune d'une pluralité de bobines RF de petite taille (202 ; 801, 802) formant un agencement à bobines multiples (105 ; 201), et mémoriser leurs signaux RMN dans une mémoire correspondant à un espace k (401) séparément pour chaque bobine RF ;

(c) calculer la distribution de sensibilité de chaque bobine (202 ; 801, 802) ;

(d) exécuter un processus de composition d'image en utilisant la distribution de sensibilité des bobines calculée à l'étape (c) et les données mesurées mémorisées dans ladite mémoire,

dans lequel les pas de gradient du champ magnétique à gradient de codage de phase (303) appliqués lors de la mesure d'une région à basse fréquence spatiale (402) dudit espace k (401) sont plus petits que ceux appliqués lors de la mesure d'une région à haute fréquence spatiale (403), dans les séquences d'impulsions exécutées de manière répétée (301 ...304),

**caractérisé en ce que** ladite étape de calcul (c) fournit la distribution de sensibilité de chaque bobine RF dans l'espace d'image en utilisant les données seulement de ladite région à basse fréquence spatiale (402) en chaque espace k (401).

2. Procédé selon la revendication 1, dans lequel on utilise un filtre passe-bas (601) pour extraire la région à basse fréquence spatiale (402) seule dudit espace k (401) lors du calcul de la distribution de sensibilité à chaque bobine RF (202 ; 801, 802), pour mettre à zéro les données de la région à haute fréquence spatiale (403) et pour former une connexion douce entre la région extraite et la région zéro.

3. Procédé selon la revendication 2, dans lequel :

la région dudit espace k (401), sauf la région où les données extraites de la région à basse fréquence spatiale (402) seule est mémorisée, est remplie de zéros avec la même densité d'échantillonnage que la région à basse fréquence spatiale, et

l'espace k (401) constitué de ces données de région à basse fréquence spatiale (402) et des données zéro de ladite autre région est soumis à une transformation de Fourier pour calculer la distribution de sensibilité des bobines.

4. Procédé selon l'une quelconque des revendications précédentes, comprenant en outre l'étape consistant à exécuter une séquence d'impulsions (301...304) pour réaliser l'image d'une deuxième image et composer ladite deuxième image en appliquant ladite distribution de sensibilité des bobines RF de petite taille (202 ; 801, 802) au signal RMN obtenu.

5. Appareil d'imagerie parallèle par résonance magnétique comprenant :

un aimant (102) agencé pour générer un champ magnétique statique et uniforme à l'intérieur d'un espace contenant un objet (101) à examiner ;

un agencement à bobines multiples (105 ; 201) composé d'une pluralité de bobines RF de petite taille (202 ; 801, 802) pour détecter un signal RMN (305) généré par ledit objet (101) ;

un moyen (103...105) adapté pour appliquer une séquence d'impulsions prédéterminée (301-304) pour de l'imagerie par RMN, la séquence d'impulsions comprenant un champ magnétique à haute fréquence (301), un champ magnétique à gradient de codage de phase (303) et un champ magnétique à gradient de lecture (304) pour prendre des images dudit objet (101) ;

un moyen de commande (111) adapté pour commander ledit moyen d'application de champ magnétique (103...105) ;

un moyen de mémorisation de données mesurées adapté pour mémoriser le signal RMN détecté dans ledit agencement à bobines multiples (105 ; 201) correspondant à chaque bobine RF de petite taille (202 ; 801, 802) ;

un moyen de calcul (503) adapté pour calculer la distribution de sensibilité de chaque bobine RF de petite taille (202 ; 801, 802) ; et

un moyen de composition d'image (504) adapté pour composer une image à partir de ladite distribution de sensibilité et desdites données mémorisées dans ledit moyen de mémorisation de données mesurées,

dans lequel le moyen de commande comprend un moyen adapté pour modifier les pas de gradient dudit champ magnétique à gradient de codage de phase (303) appliqué dans la mesure d'une région à basse fréquence spatiale (402) d'un espace k (401) pour qu'ils soient plus petits que ceux appliqués dans la mesure d'une région à haute fréquence spatiale (403),

**caractérisé en ce que** ledit moyen de calcul (503) est adapté pour fournir la distribution de sensibilité de chaque bobine RF dans l'espace d'image en utilisant seulement les données de ladite région à basse fréquence spatiale (402) dans l'espace k (401) pour chaque petite bobine (202 ; 801, 802).

6. Appareil selon la revendication 5, dans lequel ledit moyen de calcul (503) comprend :

un moyen de filtrage (601) pour extraire les données de la région à basse fréquence spatiale (402) des données mémorisées dans ledit moyen de mémorisation de données mesurées, et
un moyen (602) adapté pour effectuer une transformation de Fourier en deux dimensions aux données composées constituées de données de région à basse fréquence spatiale extraites et de données zéro remplissant la région située à l'extérieur de la région à -basse fréquence spatiale.

7. Appareil selon la revendication 6, dans lequel ledit moyen de filtrage (601) a un profil de filtre pour lisser la connexion des données entre la région à basse fréquence spatiale extraite dans la direction de codage de phase et la région à haute fréquence spatiale remplie de zéros.

8. Appareil selon l'une quelconque des revendications 5 à 7, dans lequel lesdites bobines RF de petite taille (202 ; 801, 802) sont disposées en réseau ordonné de manière à chevaucher partiellement les bobines adjacentes.

9. Appareil selon l'une quelconque des revendications 5 à 8, dans lequel :

ledit moyen de commande est adapté pour exécuter de manière répétée une mesure pour prendre des images d'une tranche prédéterminée d'un objet 101) à examiner dans une unité d'image,
ledit moyen pour calculer la distribution de sensibilité de chaque bobine RF de petite taille (202 ; 801, 802) de l'agencement à bobines multiples (105 ; 201) est adapté pour utiliser les données mesurées obtenues pour l'une des mesures exécutées de manière répétée,
ledit moyen de composition d'image (504) est adapté pour composer une image de tous les champs de vision obtenus à partir des bobines individuelles dudit agencement à bobines multiples (105 ; 201) en utilisant la distribution de sensibilité calculée à partir de ladite une des mesures exécutées de manière répétée, et pour appliquer ladite distribution de sensibilité sans renouvellement de la composition d'image basée sur les données mesurées des autres mesures exécutées de manière répétée après le calcul de la distribution de sensibilité.

10. Procédé d'imagerie parallèle par résonance magnétique pour prendre des images d'un objet (101) à examiner à haute vitesse en utilisant le phénomène de résonance magnétique, comprenant les étapes consistant à :

(a) appliquer à l'objet (101), qui est placé dans un champ magnétique statique et uniforme, une séquence d'impulsions prédéterminée (301-304) pour de l'imagerie par RMN, la séquence d'impulsions comprenant une impulsion RF (301) et un champ magnétique à gradient de lecture (304) selon une séquence d'impulsions prédéterminée, et exécuter cette séquence d'impulsions de manière répétée ;
(b) détecter des signaux RMN (305) générés par l'objet (101) en exécutant l'étape (a) en chacune d'une pluralité de bobines RF de petite taille (202 ; 801, 802) formant un agencement à bobines multiples (105 ; 201), et mémoriser leurs signaux RMN dans une mémoire correspondant à l'espace k (1200) séparément pour chaque bobine RF ;
(c) calculer la distribution de sensibilité de chaque bobine (202 ; 801, 802) ;
(d) exécuter un processus de composition d'image en utilisant la distribution de sensibilité des bobines calculée à l'étape (c) et les données mesurées mémorisées dans ladite mémoire,

dans lequel les signaux RMN dans une région à basse fréquence spatiale (1202) dudit espace k (1200) sont mesurés de façon plus dense que dans une région à haute fréquence spatiale (1203), dans les séquences d'impulsions exécutées de manière répétée (301...304), **caractérisé en ce que** ladite étape de détection (b) est faite le long d'une trajectoire en spirale à travers l'espace k (1200) et **en ce que** ladite étape de calcul (c) fournit la distribution de sensibilité de chaque bobine RF dans l'espace d'image en utilisant seulement les données de ladite région à basse fréquence spatiale (1202) en chaque espace k (1200).

**11.** Appareil d'imagerie parallèle par résonance magnétique comprenant :

un aimant (102) agencé pour générer un champ magnétique statique et uniforme à l'intérieur d'un espace contenant un objet (101) à examiner ;

un agencement à bobines multiples (105 ; 201) composé d'une pluralité de bobines RF de petite taille (202 ; 801, 802) pour détecter un signal RMN (305) généré par ledit objet (101) ;

un moyen (103...105) adapté pour appliquer une séquence d'impulsions prédéterminée (301-304) pour de l'imagerie par RMN, la séquence d'impulsions comprenant un champ magnétique à haute fréquence (301) et un champ magnétique à gradient de lecture (304) pour prendre des images dudit objet (101) ;

un moyen de mémorisation de données mesurées adapté pour mémoriser le signal RMN détecté dans ledit agencement à bobines multiples (105 ; 201) correspondant à chaque bobine RF de petite taille (202 ; 801, 802) ;

un moyen (503) adapté pour calculer la distribution de sensibilité de chaque bobine RF de petite taille (202 ; 801, 802) ; et

un moyen (504) adapté pour composer une image à partir de ladite distribution de sensibilité et des données mémorisées dans ledit moyen de mémorisation de données mesurées,

dans lequel le moyen de commande comprend un moyen adapté pour mesurer les signaux RMN dans une région à basse fréquence spatiale (1202) dudit espace k (1200) de façon plus dense que dans une région à haute fréquence spatiale (1203), **caractérisé en ce que** l'appareil comprend en outre un moyen (111) adapté pour commander ledit moyen d'application de champ magnétique (103...105) pour mesurer le long d'une trajectoire en spirale à travers l'espace k (1200) et **en ce que** ledit moyen de calcul (503) est adapté pour fournir la distribution de sensibilité de chaque bobine RF dans l'espace d'image en utilisant seulement les données de ladite région à basse fréquence spatiale (1202) dans l'espace k (1200) pour chaque petite bobine (202 ; 801, 802).

**12.** Procédé selon l'une quelconque des revendications 1 à 4, comprenant en outre l'étape consistant à obtenir une distribution de sensibilité composée (Wcomp) qui est une somme pondérée des distributions de sensibilité (Wn) de chaque bobine RF de petite taille.

**13.** Procédé ou appareil de l'une quelconque des revendications précédentes, utilisé dans une séquence d'imagerie à écho-planar (IEP).

Fig. 1

## Fig.2

EP 1 236 436 B1

to
signal processing part 107

Fig.3

Fig.4

# Fig.5

en(kx,ky): signal of RF receiving coil n

Wn(x,y): sensitivity distribution
of RF receivig coil n

EP 1 236 436 B1

# Fig.6

$e_n(kx,ky)$ : k space data

$W_n(x,y)$ : sensitivity distribution

EP 1 236 436 B1

Fig.7

EP 1 236 436 B1

Fig.8

Fig.9

Fig.10

Fig.11

RF  Gs  Ge  Gr  Echo

TE/2  TE/2

1101 1102 1103 1104 1105 1106 1107 1108

# Fig.12

EP 1 236 436 B1

Fig.13

1301

1302

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2500175 B

- JP 7031606 A

**Non-patent literature cited in the description**

- **Daniel K Sodickson ; Warren J Manning.** Simultaneous obtainment of spatial harmonics(SMASH): fast imaging with radio frequency coil arrays. *Magnetic Resonance in Medicine,* 1997, vol. 38, 591-603

- **J.Wang ; A.Reykowski.** A SMASH/SENSE related method using ratios of array coil profiles. *ISMRM 99*
- **Jakob et al.** self-calibrating technique for SMASH imaging. *MAGMA 7,* 1998, 42-54